# EUROPEAN PATENT APPLICATION

(11) **EP 4 814 572 A1**
(43) Date of publication of application: **30.09.2026**
(21) Application number: 26160314.6
(22) Date of filing: 24.02.2026
(51) Int. Cl.: G02F 1/1333, H04M 1/02

(54) **DISPLAY DEVICE**

(30) Priority: 24.03.2025 KR 20250037518
(71) Applicant: LG Display Co., Ltd., Seoul, 07336 (KR)
(72) Inventor: NAM, JiGeun, 10845 Paju-si, Gyeonggi-do (KR); PARK, HeongSoo, 10845 Paju-si, Gyeonggi-do (KR)
(74) Representative: Viering, Jentschura & Partner mbB Patent- und Rechtsanwälte

(57) **Abstract**

A display device (100) can include a display panel (110), a frame (150) disposed on a rear surface of the display panel (110) and a cover member (180) disposed on a side surface of each of the display panel (110) and the frame (150) and disposed on a part of a top surface and a part of a rear surface of the frame (150). The frame (150) can include at least one step area (158, 159), and a plurality of adhesive members (141, 142) can be stacked on the at least one step area (158, 159), thereby preventing a cover member (180) including a resin from being formed on a circuit film (185).

## Description

### BACKGROUND

### Field

The present disclosure relates to a display device, and more particularly, to a display device capable of protecting internal components of the display device.

### Discussion of the Related Art

In general, a display device includes a display area for displaying a screen and a non-display area formed along an outer portion of the display area. In addition to the display panel for displaying the screen, the display device includes various additional components such as a driving integrated circuit or a circuit board.

Additional components can be located in the non-display area, or various connection components such as a flexible printed circuit board for connecting the additional components can be located in the non-display area of the display device.

In the display device, the non-display area can be also referred to as a bezel area, and when the bezel area is thick or large, the user's gaze can be dispersed. However, when the bezel area becomes thin or small, the user's gaze can be fixed to the screen of the display area, thereby increasing the degree of immersion.

Since the decrease in the bezel area can reduce the overall size of the display device and increase the user's immersion, there is an increasing demand from consumers for the display device capable of reducing the bezel area as much as possible.

### SUMMARY OF THE DISCLOSURE

An object to be achieved by the present disclosure is to provide a display device which suppresses, minimizes or prevent a cover member including a resin from being formed on a circuit film.

Another object of the present disclosure is to provide an improved display device, which can address the limitations and disadvantages associated with the related art.

Objects of the present disclosure are not limited to the above-mentioned objects, and other objects, which are not mentioned above, can be clearly understood by those skilled in the art from the following descriptions.

Various embodiments of the present disclosure provide a display device according to claim 1. Further embodiments are described in the dependent claims. According to an aspect of the present disclosure, a display device includes a display panel, a frame disposed on a rear surface of the display panel and a cover member disposed on a side surface of each of the display panel and the frame and disposed on a part of a top surface and a part of a rear surface of the frame, where the frame includes at least one step area, and a plurality of adhesive members are stacked on the step area.

Other detailed matters of the embodiments of the present disclosure are included in the detailed description and the drawings.

According to one or more embodiments of the present disclosure, a display device capable of simplifying a material component through a uni material can be provided by disposing a plurality of adhesive members on a step area of a frame.

According to one or more embodiments of the present disclosure, it is possible to provide a display device capable of preventing or minimizing a cover member including a resin from being formed on a circuit film.

The effects according to the present disclosure are not limited to the contents exemplified above, and more various effects are included in the present disclosure.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 is a view schematically illustrating a front surface of a display device according to an example embodiment of the present disclosure.
FIG. 2 is a view schematically illustrating a rear surface of a display device according to an example embodiment of the present disclosure.
FIG. 3 is a plan view illustrating a rear surface of a display device according to an example embodiment of the present disclosure.
FIG. 4 is a cross-sectional view taken along line A-B of FIG. 3 according to an example of the present disclosure.
FIG. 5 is a plan view illustrating an adhesive member and a frame of a display device according to an example embodiment of the present disclosure.
FIG. 6 is an enlarged view of an area X of FIG. 5 according to an example of the present disclosure.
FIG. 7 is an enlarged view of an area Y of FIG. 6 according to an example of the present disclosure.
FIG. 8 is a view schematically illustrating a cross-sectional structure cut along the C-D of FIG. 3.
FIG. 9 is a view illustrating a cover member disposed on a part of an upper surface of a frame.
FIG. 10 is a view illustrating that a cover member is disposed on a part of a rear surface of a frame.
FIG. 11 is an image in which a cover member is formed on a frame of a display device according to a comparative example.
FIG. 12 is an enlarged view of an area Z of FIG. 11.
FIG. 13 is an image of a cover member on a frame of a display device according to an example embodiment of the present disclosure.

### DETAILED DESCRIPTION OF THE EMBODIMENTS

Advantages and characteristics of the present disclosure and a method of achieving the advantages and characteristics will be clear by referring to example embodiments described below in detail together with the accompanying drawings. However, the present disclosure is not limited to the example embodiments disclosed herein but will be implemented in various forms. The example embodiments are provided by way of example only so that those skilled in the art can fully understand the disclosures of the present disclosure and the scope of the present disclosure.

The shapes, sizes, ratios, angles, numbers, and the like illustrated in the accompanying drawings for describing the example embodiments of the present disclosure are merely examples, and the present disclosure is not limited thereto. Further, in the following description of the present disclosure, a detailed explanation of known related technologies can be omitted to avoid unnecessarily obscuring the subject matter of the present disclosure. The terms such as "including," "having," and "consist of" used herein are generally intended to allow other components to be added unless the terms are used with the term "only". Any references to singular can include plural unless expressly stated otherwise.

Components are interpreted to include an ordinary error range even if not expressly stated.

When the position relation between two parts is described using the terms such as "on", "above", "below", and "next", one or more parts can be positioned between the two parts unless the terms are used with the term "immediately" or "directly".

When an element or layer is disposed "on" another element or layer, another layer or another element can be interposed directly on the other element or therebetween.

Although the terms such as "first", "second", and the like are used for describing various components, these components are not confined by these terms. These terms are merely used for distinguishing one component from the other components and may not define order or sequence. Therefore, a first component to be mentioned below can be a second component in a technical concept of the present disclosure.

Like reference numerals generally denote like elements throughout the disclosure.

A size and a thickness of each component illustrated in the drawing are illustrated for convenience of description, and the present disclosure is not limited to the size and the thickness of the component illustrated.

The features of various embodiments of the present disclosure can be partially or entirely adhered to or combined with each other and can be interlocked and operated in technically various ways, and the embodiments can be carried out independently of or in association with each other. Further, the term "can" fully encompasses all the meanings and coverages of the term "may" and vice versa.

Hereinafter, embodiments of the present disclosure will be described in detail with reference to the drawings. All the components of each display device/apparatus according to all embodiments of the present disclosure are operatively coupled and configured.

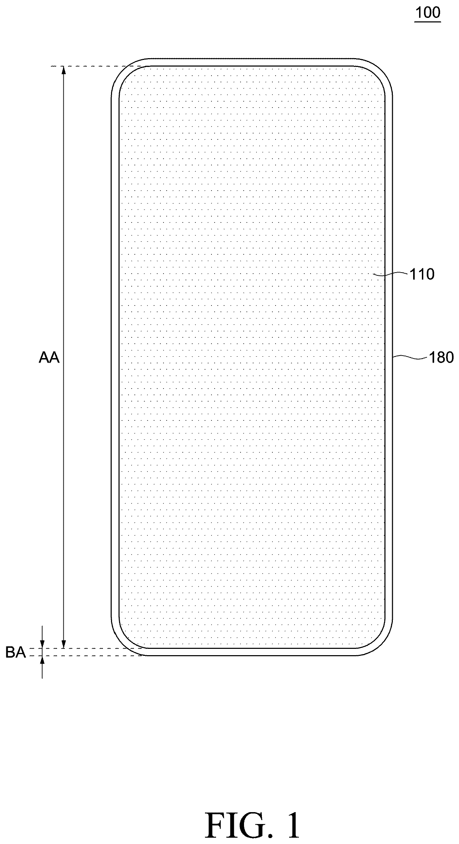

FIG. 1 is a view schematically illustrating a front surface of a display device according to an example embodiment of the present disclosure.

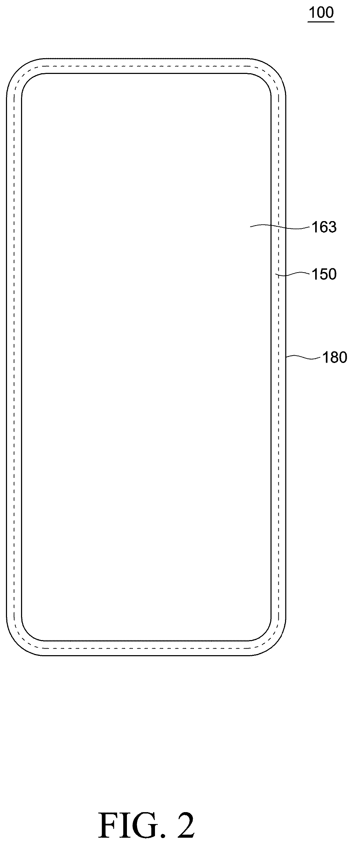

FIG. 2 is a view schematically illustrating a rear surface of a display device according to an example embodiment of the present disclosure.

Referring to FIGS. 1 and 2, a display device 100 can include a display panel 110, a frame 150, a first back plate 163, and a cover member 180.

The display device 100 can include a display area AA (or active area) in which an image is displayed and a bezel area BA surrounding the display area AA.

At least a portion of the cover member 180 can be disposed to overlap the bezel area BA.

Specifically, the cover member 180 can be disposed to surround the side surface of the display panel 110, the side surface of the frame 150, and the side surface of the first back plate 163.

The cover member 180 is disposed to surround side surfaces of the display panel 110, the frame 150, and the first back plate 163 to serve to protect the display panel 110 and the first back plate 163.

However, the present disclosure is not limited thereto, and a part of the cover member 180 can overlap a part of an upper surface or a rear surface of each of the display panel 110, the frame 150, and the first back plate 163.

The cover member 180 can include a polymer epoxy-based resin material, but is not limited thereto. For example, the cover member 180 can include a resin that can be cured when light is irradiated.

The first back plate 163 can be disposed on the rear surface of the display panel 110 and serve to support the display panel 110.

The frame 150 can be disposed on the rear surface of the first back plate 163.

The frame 150 can include at least one opening, and at least a portion of each of the display panel 110 and the first back plate 163 can be accommodated in the opening of the frame 150.

The display device 100 according to an example embodiment of the present disclosure can further include a set cover enclosing a cover member 180 and a frame 150. In this case, the set cover can be disposed to surround the entire bezel area BA of the display device 100 and the entire rear surface of the display device 100.

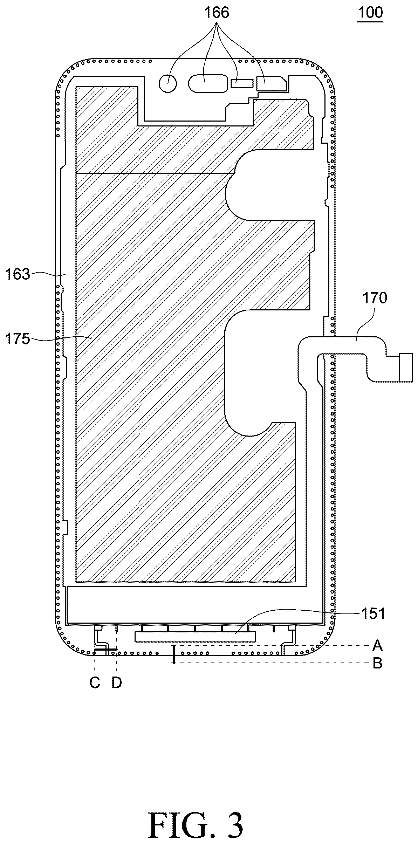

FIG. 3 is a plan view illustrating a rear surface of a display device according to an example embodiment of the present disclosure.

Referring to FIG. 3, a display device 100 according to an example embodiment of the present disclosure can include a frame 150, a first back plate 163, a heat dissipation sheet 175, and a circuit board 170.

Specifically, the heat dissipation sheet 175 can be disposed on a part of the rear surface of the first back plate 163. Accordingly, it is possible to prevent damage to the display panel due to heat generated when the display device 100 is driven.

The heat dissipation sheet 175 may not overlap at least one optical electronic device 166 included in the display device 100. Here, the optical electronic device 166 can include one or more of a photographing device such as a camera (image sensor), a proximity sensor, and a detection sensor such as an illuminance sensor.

The electronic optical device 166 of the display device 100 can be disposed in the non-display area of the display panel 110, but is not limited thereto. For example, at least a partial area in which the optical electronic device 166 is disposed can overlap at least one sub pixel disposed in the display area of the display panel 110.

The heat dissipation sheet 175 may not overlap the circuit board 170. Here, the circuit board 170 can be a flexible printed circuit board, but is not limited thereto.

The heat dissipation sheet 175 may not overlap the frame 150.

The frame 150 can include at least one groove 151 in which a circuit film on which a driver integrated circuit is mounted is disposed.

At least one groove 151 of the frame 150 may not overlap the heat dissipation sheet 175.

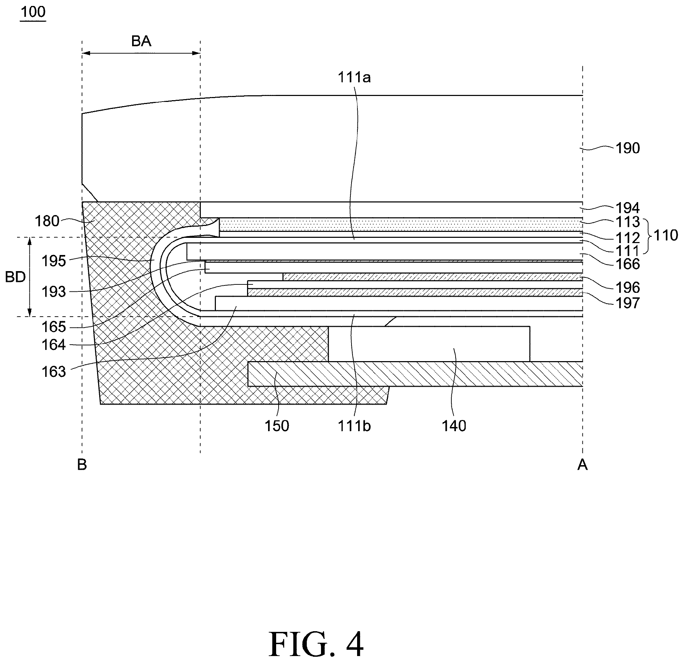

Next, a laminated structure of the display device 100 according to the example embodiment of the present disclosure will be described in detail with reference to FIG. 4.

FIG. 4 is a cross-sectional view taken along line A-B of FIG. 3.

Referring to FIG. 4, a display device 100 according to an example embodiment of the present disclosure can include a display panel 110, an adhesive member 140, a frame 150, a first back plate 163, a first metal plate 164, a second metal plate 165, a second back plate 165, a cover member 180, a polarizing plate 194, and a cover glass 190.

Specifically, the polarizing plate 194 can be disposed under the cover glass 190. However, the present disclosure is not limited thereto, and in some cases, the polarizing plate 194 can be omitted.

The display panel 110 can be disposed below the cover glass 190 and the polarizing plate 194.

The display panel 110 can include a first substrate 111, a display element layer 112, and a second substrate 113.

Specifically, the second substrate 113 can be disposed below the polarizing plate 194.

The display element layer 112 can be disposed below the second substrate 113. The display element layer 112 can include a plurality of thin film transistors and a plurality of light emitting elements disposed on the plurality of thin film transistors. Further, the display element layer 112 can include a plurality of touch electrodes and a plurality of touch lines disposed on the plurality of light emitting elements.

The first substrate 111 can be disposed below the display element layer 112. The first substrate 111 can include an organic insulating material. For example, the first substrate 111 can include polyimide (PI), but is not limited thereto.

The first substrate 111 can include a first region 111a, a bending region BD, and a second region 111b.

The first region 111a can include an area disposed between the display element layer 112 and the second back plate 166. The bending region BD can include an area extending from the first region 111a, in which the first substrate 111 is bent in one direction. The second region 111b extends from the bending region BD and can be an area disposed between the first back plate 163 and the frame 150.

At least one layer of the micro coating layer MCL 195 can be disposed on the bending region BD of the first substrate 111. The micro coating layer 195 can serve to prevent cutting and damage of the types of lines disposed in the bending region BD of the first substrate 111.

A second back plate 166 can be disposed below the first region 111a of the first substrate 111.

A second metal plate 165 can be disposed below the second back plate 166.

A first adhesive layer 195 can be disposed between the second back plate 166 and the second metal plate 165. The second back plate 166 and the second metal plate 165 can be fixed to each other through the first adhesive layer 195.

The first metal plate 164 can be disposed below the second metal plate 165.

A second adhesive layer 196 can be disposed between the second metal plate 165 and the first metal plate 164.

A first back plate 163 can be disposed below the first metal plate 164.

A third adhesive layer 197 can be disposed between the first metal plate 164 and the first back plate 163.

Each of the first adhesive layer 195, the second adhesive layer 196, and the third adhesive layer 197 can be a double-sided tape, but is not limited thereto.

The first substrate 111 of the display panel 110 can be disposed on a part of the rear surface of the first back plate 163. The first substrate 111 disposed on the rear surface of the first back plate 163 can be an area extending from the bending region BD of the first substrate 111.

A circuit film on which a driver integrated circuit is mounted can be connected to one side of the first substrate 111 disposed on the rear surface of the first back plate 163.

Each of the first back plate 163, the first metal plate 164, the second metal plate 165, and the second back plate 166 can be disposed between the first region 111a and the second region 111b of the first substrate 111 and serve to support the first substrate 111.

The adhesive member 140 can be disposed below the second region 111b of the first substrate 111.

The frame 150 can be disposed below the adhesive member 140. The frame 150 can be selected from any one of stainless steel (SUS), polyethylene terephthalate (PET), and polycarbonate (PC), but is not limited thereto.

The cover member 180 can be disposed below the cover glass 190.

The cover member 180 can be disposed to surround side surfaces of the polarizing plate 194, the display panel 110, the first back plate 163, the first metal plate 164, the second metal plate 165, the second back plate 166, the adhesive member 140, and the frame 150.

Further, the cover member 180 can be disposed on a part of the top surface and a part of the rear surface of the frame 150.

The display device 100 can further include a set cover which encloses a side surface of the cover member 180, a rear surface of the cover member 180, and a rear surface of the frame 150.

In the meantime, when the width of the bezel area BA of the display device 100 is narrow, an area which can be occupied by the set cover is reduced so that it can be difficult to fasten the set cover.

The cover member 180 of the display device 100 according to the example embodiment of the present disclosure is disposed to surround the side surfaces of the polarizing plate 194 (which can be also referred to as a polarizer), the display panel 110, the first back plate 163, the first metal plate 164, the second metal plate 165, the second back plate 166, the adhesive member 140, and the frame 150, and is disposed on a part of the upper surface and a part of the rear surface of the frame 150 to increase a surface area to which the set cover can be fastened even if the width of the bezel area BA is not increased. Accordingly, even when the set cover is fastened, the fastening failure can be reduced.

Meanwhile, the cover member 180 can be formed by a process of disposing a mold to surround each component in a state in which the cover glass 190, the polarizing plate 194, the display panel 110, the first back plate 163, the first metal plate 164, the second metal plate 165, the second back plate 166, and the frame 150 are fastened, injecting a resin into the mold, curing the resin using light, and removing the mold.

However, since the material for forming the cover member 180 has a high flowability, there can be a problem in that the material of the cover member 180 is disposed to cover other desired configurations.

For example, the cover member 180 is disposed on a part of the upper surface of the frame 150 and is disposed so as not to overlap the groove 151 of the frame 150. When the cover member 180 is formed to the groove 151 of the frame 150, the circuit film disposed in the groove 151 is covered by the cover member 180, which can cause a problem in driving the display panel 110.

In the process of forming the cover member 180 by disposing the adhesive member 140 between the frame 150 and the second region 111b of the first substrate 111, the display device 100 according to the example embodiment of the present disclosure can stably drive the display panel 110 by preventing the material of the cover member 180 from penetrating into the groove 151 of the frame 150.

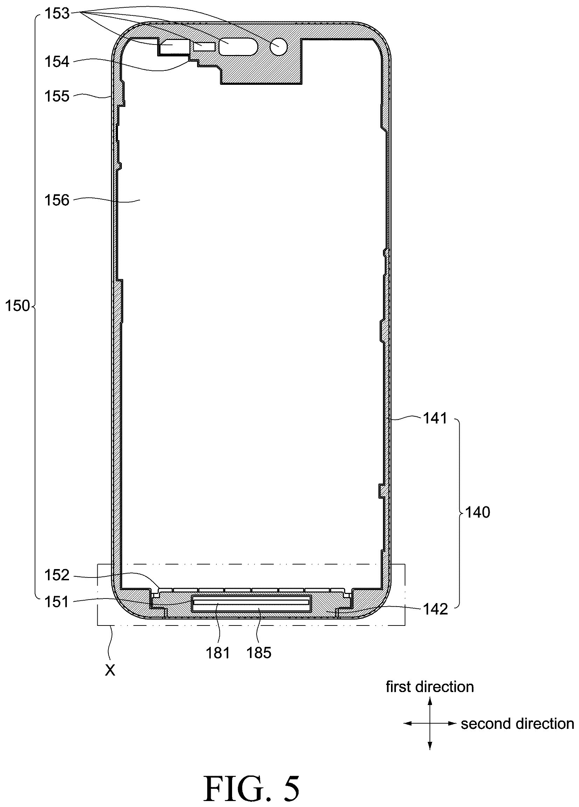

Next, a structure of the adhesive member 140 and the frame 150 of the display device 100 according to the embodiment of the present disclosure will be reviewed with reference to FIG. 5.

FIG. 5 is a plan view illustrating an adhesive member and a frame of a display device according to an example embodiment of the present disclosure.

Referring to FIG. 5, the frame 150 can include at least one groove 151, a first extension portion 152, at least one first hole 153, a second extension portion 154, an edge 155, and an opening 156.

The edge 155 of the frame 150 can have a rectangular frame shape, and can have rounded corners. In an example, the edge 155 can be a quadrangular edge.

Each of the first extension portion 152 and the second extension portion 154 can be a portion extending from a portion of the edge 155.

At least one groove 151 of the frame 150 can be disposed in the first extension portion 152 integrally formed with the edge 155 of the frame 150.

The circuit film 185 on which the driver integrated circuit 181 is mounted can be disposed on one surface of the frame 150. For example, the circuit film 185 on which the driver integrated circuit 181 is mounted can be disposed in at least one groove 151 of the frame 150.

Since the circuit film 185 on which the driver integrated circuit 181 is mounted is disposed in the groove 151 of the frame 150, it is possible to suppress the occurrence of a step at the boundary between the circuit film 185 and the frame 150. Accordingly, the circuit film 185 is disposed to protrude from one surface of the frame 150 to prevent the circuit film 185 from being damaged due to interference caused by the components of the display device 100.

The frame 150 can include at least one first hole 153. The at least one first hole 153 of the frame 150 can be disposed in the second extension portion 154 integrally formed with the edge 155 of the frame 150.

At least one first hole 153 of the frame 150 can overlap the optical electronic device 166 of the display device 100. FIG. 5 illustrates a structure in which one first hole 153 corresponds to one optical electronic device 166, but the structure of the frame 150 is not limited thereto.

The first extension portion 152 and the second extension portion 154 of the frame 150 can be disposed to face each other with respect to the first direction. Here, the first direction can be a direction in which the long side of the edge 155 of the frame 150 extends.

The frame 150 can have a length in the first direction longer than a length in the second direction that is a direction intersecting the first direction.

The frame 150 can include an opening 156 surrounded by an edge 155, a first extension portion 152, and a second extension portion 154. Further, at least a part of the display panel 110 can be disposed in the opening 156 of the frame 150.

The adhesive member 140 can be disposed on a part of the upper surface of the frame 150. The adhesive member 140 can include a first adhesive member 141 and a second adhesive member 142.

A first adhesive member 141 can be disposed on the edge 155 of the frame 150 and the second extension portion 154.

The first adhesive member 141 can also be disposed on a part of the first extension portion 152 of the frame 150. Specifically, the first adhesive member 141 may not be disposed in an area in which the groove 151 of the first extension portion 152 of the frame 150 is disposed and in a peripheral area of the groove 151.

The first adhesive member 141 disposed on the edge 155 of the frame 150, the second extension portion 154, and a part of the first extension portion 152 can be integrally formed, but is not limited thereto.

The first adhesive member 141 (which can be also referred to as the first bonding member) can be a double-sided tape to which an upper surface and a rear surface are bondable.

The first adhesive member 141 is disposed on the edge 155 of the frame 150, the second extension portion 154, and a part of the first extension portion 152 so that the display panel 110 is stably seated in the frame 150 to prevent damage to the display panel 110 due to external force or movement.

The second adhesive member 142 can be disposed on the other part of the first extension portion 152 of the frame 150.

Specifically, the second adhesive member 142 may not be disposed in an area in which the groove 151 of the first extended portion 152 of the frame 150 is disposed.

The second adhesive member 142 (which can be also referred to as the second bonding member) can be a double-sided tape to which an upper surface and a rear surface are bondable.

Since the second adhesive member 142 is not disposed in the groove 151 of the first extension portion 152, the second adhesive member 142 may not overlap the entire circuit film 185 on which the driver integrated circuit 181 is mounted, thereby preventing damage to the driver integrated circuit 181 and the circuit film 185 due to the second adhesive member 142.

Further, the second adhesive member 142 can prevent or minimize contact defects/issues from occurring with various pads disposed on the display panel 110 in the driver integrated circuit 181 and the circuit film 185.

A part of the first adhesive member 141 and a part of the second adhesive member 142 can overlap each other.

Specifically, the first extension portion 152 can include at least one step area, and the first adhesive member 141 and the second adhesive member 142 can overlap each other on an upper surface of the step area of the first extension portion 152.

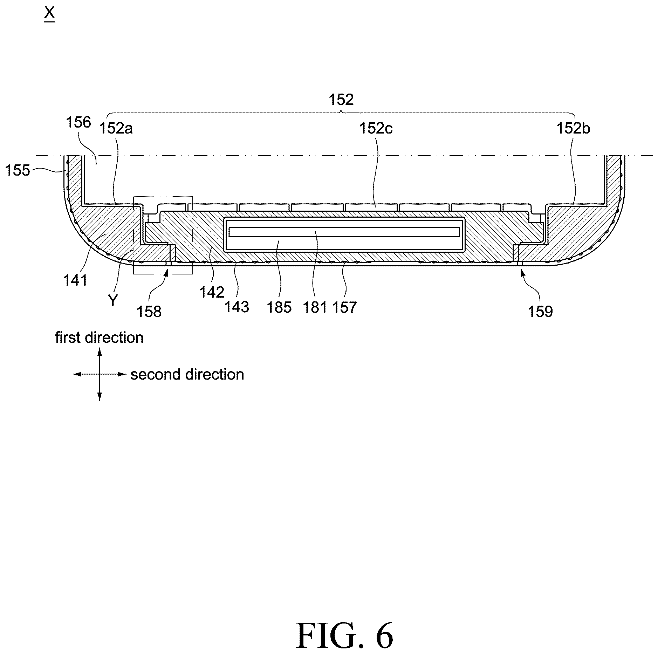

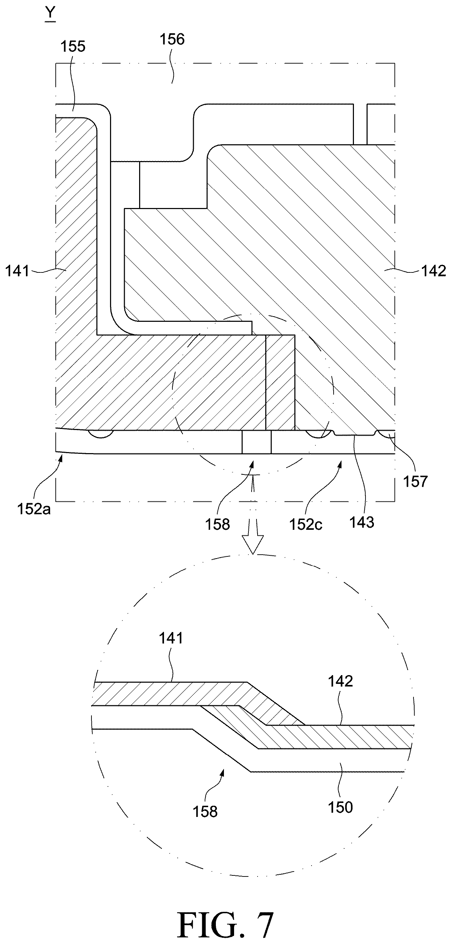

Next, the first adhesive member 141 and the second adhesive member 142 will be specifically reviewed with reference to FIGS. 6 and 7.

FIG. 6 is an enlarged view of an area X of FIG. 5.

FIG. 7 is an enlarged view of an area Y of FIG. 6.

Referring to FIGS. 6 and 7, the first extension portion 152 of the frame 150 can include a first sub area 152a, a second sub area 152b, and a third sub area 152c.

The first sub area 152a can be an area extending from a portion of the edge 155 extending in the first direction.

The second sub area 152b can be an area extending from another portion of the edge 155 extending in the first direction.

A portion of the edge 155 with the first sub area 152a extending can be disposed to face the other portion of the edge 155 with the second sub area 152b extending.

The third sub area 152c can be an area disposed between the first sub area 152a and the second sub area 152b.

A first step area 158 can be disposed between the first sub area 152a and the third sub area 152c. A second step area 159 can be disposed between the second sub area 152b and the third sub area 152c.

The first step area 158 can be disposed in a partial region between the first sub area 152a and the third sub area 152c. For example, the first step area 158 can be disposed to be adjacent to a plurality of second holes 157 provided in the frame 150.

The second step area 159 can be disposed in a partial region between the second sub area 152b and the third sub area 152c. For example, the second step area 159 can be disposed to be adjacent to a plurality of second holes 157 provided in the frame 150.

Meanwhile, the shortest length to the top surface of the third sub area 152c and the rear surface of the cover glass 190 can be longer than the shortest length to the top surface of each of the first sub area 152a and the second sub area 152b and the rear surface of the cover glass 190 due to the first step area 158 and the second step area 159.

A plurality of second holes 157 which are spaced apart from each other can be disposed on the edge 155 of the frame 150.

At least some of the plurality of second holes 157 can overlap the cover member 180 disposed on the frame 150.

By disposing the plurality of second holes 157 on the edge 155 of the frame 150, the surface area of the frame 150 can be increased, and accordingly, the adhesive strength between the frame 150 and the cover member 180 can be improved.

Accordingly, even if the cover member 180 is disposed on the frame 150, it is possible to prevent the frame 150 and the cover member 180 from being separated from each other by an external force.

The second adhesive member 142 can also be disposed on a portion of the edge 155 of the frame 150. In this case, the second adhesive member 142 may not overlap the plurality of second holes 157 disposed at the edge 155.

Specifically, the second adhesive member 142 can include a protruding region 143 disposed between one second hole 157 and another adjacent second hole 157. Further, the second adhesive member 142 and the protruding region 143 may not overlap the plurality of second holes 157.

Since the second adhesive member 142 is disposed to expose the plurality of second holes 157, the surface area of the frame 150 is increased through the plurality of second holes 157, so that the adhesive strength between the frame 150 and the cover member 180 can be improved.

A driver integrated circuit 181 and a circuit film 185 on which the driver integrated circuit 181 is mounted can be disposed in a part of the third sub area 152c.

Specifically, at least one groove 151 can be disposed in the third sub area 152c. A circuit film 185 on which the driver integrated circuit 181 is mounted can be disposed in at least one groove 151 disposed in the third sub area 152c.

A first adhesive member 141 can be disposed in each of the first sub area 152a and the second sub area 152b.

A second adhesive member 142 can be disposed in a portion of the third sub area 152c. The second adhesive member 142 can be disposed in the remaining area excluding the groove 151 of the third sub area 152c.

The frame 150 can include at least one step area 158 and 159 and a plurality of adhesive members 140 can be stacked on the step areas 158 and 159.

Specifically, the first adhesive member 141 and the second adhesive member 142 can be disposed to overlap the first step area 158 and the second step area 159.

For example, in the first step area 158 and the second step area 159, the second adhesive member 142 can be disposed on the frame 150, and the first adhesive member 141 can be disposed on the second adhesive member 142.

However, the positions of the first adhesive member 141 and the second adhesive member 142 are not limited thereto. For example, in the first step area 158 and the second step area 159, the first adhesive member 141 can be disposed on the frame 150, and the second adhesive member 142 can be disposed on the first adhesive member 141.

As described above, the first adhesive member 141 and the second adhesive member 142 are disposed to overlap each of the first step area 158 and the second step area 159 so that in the process of forming the cover member 180 on the frame 150, the material of the cover member 180 may not spread to the groove 151 of the third sub area 152c.

Specifically, the first adhesive member 141 and the second adhesive member 142 which are disposed to overlap each other in the first step area 158 and the second step area 159 can serve as dams that prevent the material of the cover member 180 from spreading to the groove 151.

When the adhesive member is not disposed on the upper portion of the frame 150 in the first step area 158 and the second step area 159, the material of the cover member 180 may not be prevented from spreading to the groove 151, so that the material of the cover member 180 can spread to the circuit film 185 disposed in the groove 151 or the driver integrated circuit 181 mounted on the circuit film 185.

When the material of the cover member 180 is cured in a spread state on the circuit film 185 and the driver integrated circuit 181, electrical connection between the circuit film 185 and the display panel 110 becomes difficult, making normal driving of the display panel 110 impossible.

However, in the display device 100 according to the example embodiment of the present disclosure, the second adhesive member 142 disposed on the first step area 158 and the first adhesive member 141 disposed on the second adhesive member 142 are included to protect the circuit film 185 and the driver integrated circuit 181 from the cover member 180.

In addition, there is an effect of simplifying the material component of the display device 100 through the uni material through the structure in which the second adhesive member 142 and the first adhesive member 141 are stacked on the first step area 158 of the frame 150.

Specifically, a plurality of adhesive members 140 which can fill a space between the frame 150 and the display panel 110 are disposed on the first step area 158 of the frame 150 so that the material of the cover member 180 can be prevented from flowing into the circuit film 185 during the process of forming the cover member 180, and a separate structure for filling a space between the frame 150 and the display panel 110 does not need to be formed, thereby simplifying the structure of the display device 100 and the material parts.

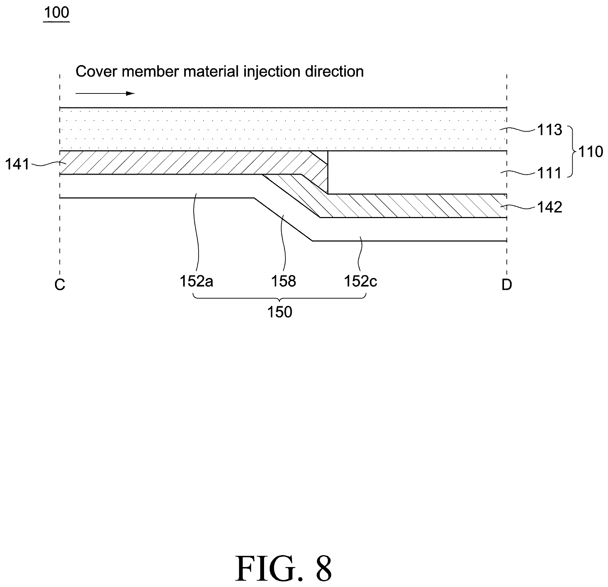

This will be described in detail with reference to FIG. 8.

FIG. 8 is a view schematically illustrating a cross-sectional structure cut along the C-D of FIG. 3.

In FIG. 8, the structure of the display device 100 according to the embodiment of the present disclosure is described based on the first sub area 152a, the third sub area 152c, and the first step area 158 disposed between the first sub area 152a and the third sub area 152c. However, the present disclosure is not limited thereto. For example, structures of the components disposed on the second sub area 152b, the third sub area 152c, and the second step area 159 disposed between the second sub area 152b and the third sub area 152c can also be applied in the same manner as in FIG. 8.

Hereinafter, for convenience of description, the description will be made based on the first sub area 152a, the third sub area 152c, and the first step area 158 disposed between the first sub area 152a and the third sub area 152c.

Referring to FIG. 8, the first adhesive member 141, the second adhesive member 142, and the frame 150 can be disposed below the display panel 110.

The frame 150 can include a first sub area 152a, a third sub area 152c, and a first step area 158.

Since the frame 150 includes the first step area 158, the shortest distance between the top surface of the first sub area 152a and the rear surface of the second substrate 113 of the display panel 110 can be closer than the shortest distance between the top surface of the third sub area 152c and the rear surface of the second substrate 113 of the display panel 110.

Further, since the frame 150 includes the first step area 158, the frame 150 can include a space in which the second region 111b of the first substrate 111 of the display panel 110 and the circuit film 185 connected to the second region 111b can be disposed.

A first adhesive member 141 can be disposed on the top surface of the first sub area 152a of the frame 150.

The first adhesive member 141 can be disposed on the top surface of the first sub area 152a and serve to fix a partial area of the display panel 110 to the frame 150. For example, the first adhesive member 141 can serve to fix the second substrate 113 of the display panel 110 onto the first sub area 152a of the frame 150.

However, this is only an example, and the first adhesive member 141 can serve to fix any one of the first back plate 163, the first metal plate 164, the second metal plate 165, and the second back plate 166 disposed below the display panel 110 and the frame 150.

The second adhesive member 142 is disposed on the top surface of the third sub area 152c to fix a partial area of the display panel 110 to the frame 150. For example, the second adhesive member 142 can serve to fix the first substrate 111 of the display panel 110 onto the third sub area 152c of the frame 150.

Further, since the frame 150 includes the first step area 158, a space can be provided between the second region 111b of the first substrate 111 of the display panel 110 and the third sub area 152c. The second adhesive member 142 can serve to fill another space in which the circuit film 185 is not disposed, among spaces provided between the second area 111b and the third sub area 152c.

The material of the cover member 180 can be injected from the outside of the frame 150 to form the cover member 180 in a state in which the display panel 110 is attached onto the frame 150.

When a material of the cover member 180 having a high flowability is injected, the material can flow from the first sub area 152a to the third sub area 152c in which the circuit film 185 is disposed through the first step area 158.

However, the second adhesive member 142 and the first adhesive member 141 disposed on the second adhesive member 142 are disposed on the first step area 158 to block a space between the first step area 158 and the display panel 110, thereby preventing the material of the cover member 180 from flowing into the third sub area 152c.

Accordingly, there is no need for a separate structure or process for preventing the material of the cover member 180 from flowing into the third sub area 152c, thereby simplifying the process and reducing costs.

Meanwhile, cross-sectional shapes of the first adhesive member 141 and the second adhesive member 142 of FIG. 8 can be the same as those of FIG. 7, but are not limited thereto and can be formed in a shape as shown in FIG. 8.

For example, FIG. 8 can be a cross-sectional structure in which the first substrate 111 is disposed at a boundary between the first step area 158 and the third sub area 152c, and FIG. 7 can be a cross-sectional structure in which the first substrate 111 is disposed to be spaced apart from a boundary between the first step area 158 and the third sub area 152c.

The shape of the end of the first adhesive member 141 can vary depending on the position of the first substrate 111, but is not limited thereto.

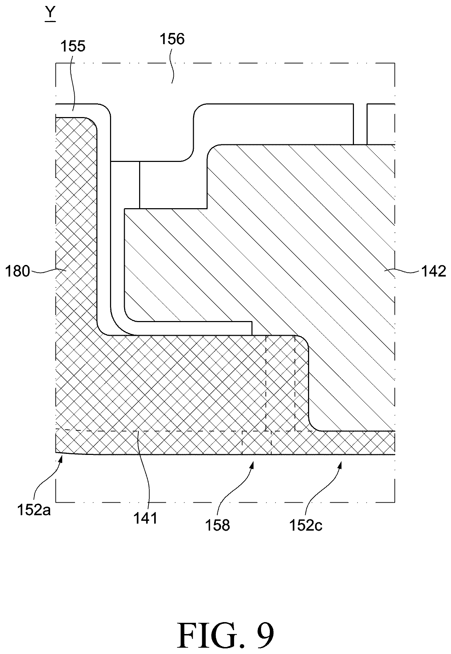

FIG. 9 is a view illustrating a cover member disposed on a part of an upper surface of a frame.

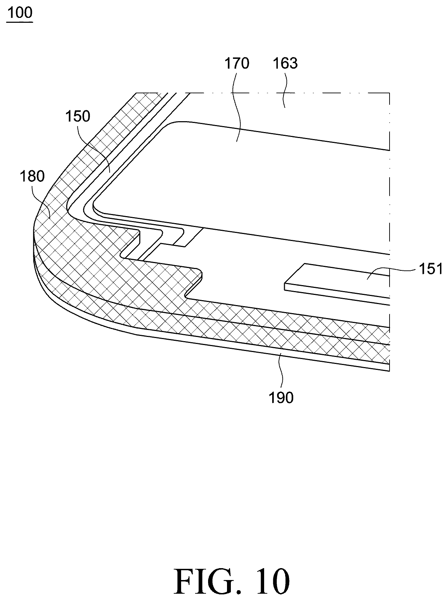

FIG. 10 is a view illustrating that a cover member is disposed on a part of a rear surface of a frame.

Referring to FIGS. 9 and 10, the cover member 180 can be disposed on a part of the upper surface and a part of the rear surface of the frame 150.

Specifically, the cover member 180 may not overlap the first adhesive member 141 and the second adhesive member 142 disposed on the first step area 158 of the frame 150.

In addition, the cover member 180 can be disposed on the first sub area 152a and the edge 155 of the frame 150.

The cover member 180 can overlap at least a portion of the first adhesive member 141 and may not overlap the second adhesive member 142.

Specifically, the cover member 180 can overlap at least a portion of the first adhesive member 141 in each of the edge 155 and the first sub area 152a. In addition, the cover member 180 may not penetrate up to the third sub area 152c due to the first adhesive member 141 and the second adhesive member 142 disposed in the first step area 158, so the cover member 180 may not overlap the second adhesive member 142 disposed in the third sub area 152c.

Further, the cover member 180 can be disposed on a part of the rear surface of the frame 150. The cover member 180 can be disposed from a part of the upper surface of the frame 150 to a part of the rear surface of the frame 150 that surrounds the side surface of the frame 150.

Accordingly, an area to which the set cover disposed outside the cover member 180 can be fastened is widened so that the set cover can be stably fastened even in the display device 100 having a narrow bezel area BA.

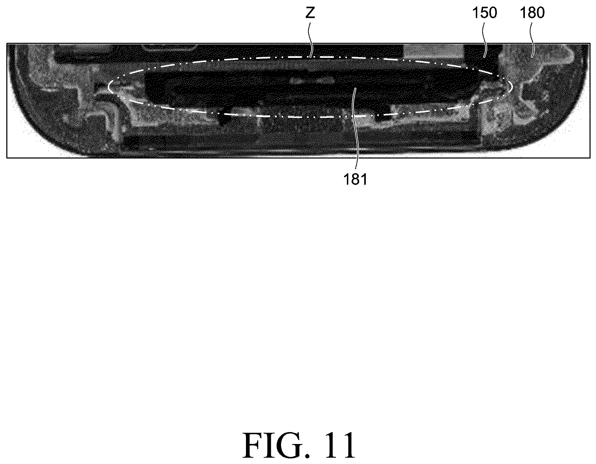

Next, a display device according to a comparative example and a display device according to an example embodiment of the present disclosure are compared with each other with reference to FIGS. 11 to 13.

FIG. 11 is an image in which a cover member is formed on a frame of a display device according to a comparative example.

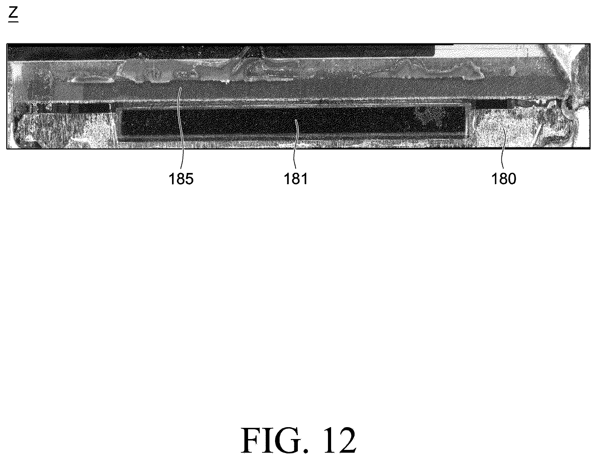

FIG. 12 is an enlarged view of an area Z of FIG. 11.

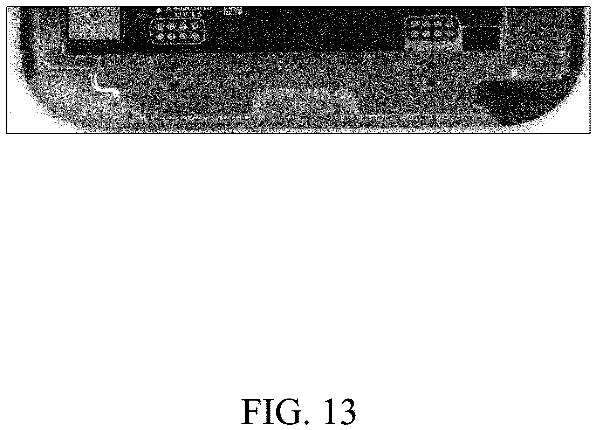

FIG. 13 is an image of a cover member on a frame of a display device according to an example embodiment of the present disclosure.

The display device according to the comparative example of FIGS. 11 and 12 has a structure in which the first adhesive member 141 and the second adhesive member 142 are not disposed in the first step area 158 and the second step area 159 of the frame 150.

First, referring to FIGS. 11 and 12, it can be seen that the material of the cover member 180 formed on the frame 150 is cured while spreading to the driver integrated circuit 181 and the circuit film 185.

Specifically, as illustrated in FIG. 12, a cover member 180 is formed on a part of the circuit film 185 and a part of the driver integrated circuit 181, which causes defects in the circuit film 185 and the driver integrated circuit 181.

In contrast, in the display device according to one or more embodiments of the present disclosure, as described with reference to FIGS. 5 to 10, the first adhesive member 141 and the second adhesive member 142 are disposed on the frame 150, such that the cover member 180 is not formed on the driver integrated circuit 181 and the circuit film 185.

According to an aspect of the present disclosure, a display device includes a display panel, a frame disposed on a rear surface of the display panel and a cover member disposed on a side surface of each of the display panel and the frame and disposed on a part of a top surface and a part of a rear surface of the frame, where the frame includes at least one step area, and a plurality of adhesive members are stacked on the step area.

According to another aspect of the present disclosure, the frame can include a rectangular edge, an opening surrounded by the edge, and an extension portion disposed between the edge and the opening and extending from a portion of the edge, the extension portion can include a first sub area, a second sub area, and a third sub area disposed between the first sub area and the second sub area.

According to another aspect of the present disclosure, the plurality of adhesive members can include a first adhesive member and a second adhesive member, the first adhesive member can be disposed on each of the first sub area and the second sub area, and the second adhesive member can be disposed on a part of the third sub area.

According to another aspect of the present disclosure, the third sub area includes at least one groove, and a circuit film on which a driver integrated circuit is mounted can be disposed in the groove.

According to another aspect of the present disclosure, the groove of the third sub area may not overlap the second adhesive member.

According to another aspect of the present disclosure, the cover member may not overlap the driver integrated circuit and the circuit film.

According to another aspect of the present disclosure, the first adhesive member can be disposed to extend to an edge.

According to another aspect of the present disclosure, each of the first adhesive member and the second adhesive member can be a double-sided tape.

According to another aspect of the present disclosure, the at least one step area can include a first step area and a second step area, and in each of the first step area and the second step area, a portion of each of the first adhesive member and the second adhesive member may not overlap the cover member.

According to another aspect of the present disclosure, the plurality of adhesive members can include a first adhesive member and a second adhesive member, and the first adhesive member and the second adhesive member can overlap each other in direct contact with each other.

According to another aspect of the present disclosure, the frame can include a first sub area, a second sub area, and a step area among the at least one step area disposed between the first and second sub areas, and the second adhesive layer can cover the second sub area and the step area.

According to another aspect of the present disclosure, the first adhesive member can cover the first sub area, the step area and a part of the second sub area.

According to another aspect of the present disclosure, an edge of the first adhesive member can abut an edge of a first substrate of the display panel.

According to another aspect of the present disclosure, the edge of the first adhesive members can be a vertical edge.

## Claims

1. A display device (100), comprising:
a display panel (110);
a frame (150) disposed on a rear surface of the display panel (110); and
a cover member (180) disposed on a side surface of the display panel (110) and a side surface of the frame (150), the cover member (180) being disposed on a part of a top surface and a part of a rear surface of the frame (150),
wherein the frame (150) includes at least one step area (158, 159), and
wherein a plurality of adhesive members (141, 142) are stacked on the at least one step area (158, 159) of the frame (150).

2. The display device (100) according to claim 1, wherein the frame (150) includes an edge (155), an opening (156) surrounded by the edge (155), and an extension portion (152) disposed between the edge (155) and the opening (156) and extending from a portion of the edge (155).

3. The display device (100) according to claim 2, wherein the extension portion (152) of the frame (150) includes a first sub area (152a), a second sub area (152b), and a third sub area (152c) disposed between the first sub area (152a) and the second sub area (152b).

4. The display device (100) according to claim 3, wherein the plurality of adhesive members (141, 142) include a first adhesive member (141) and a second adhesive member (142), and
wherein the first adhesive member (141) is disposed on each of the first sub area (152a) and the second sub area (152b).

5. The display device (100) according to claim 4, wherein the second adhesive member (142) is disposed on a part of the third sub area (152c).

6. The display device (100) according to claim 4 or 5, wherein the third sub area (152c) includes at least one groove (151), and
wherein a circuit film (185) on which a driver integrated circuit (181) is mounted is disposed in the at least one groove (151) of the third sub area (152c).

7. The display device (100) according to claim 6, wherein the at least one groove (151) of the third sub area (152c) does not overlap the second adhesive member (142).

8. The display device (100) according to claim 6 or 7, wherein the cover member (180) does not overlap the driver integrated circuit (181) and the circuit film (185).

9. The display device (100) according to any of claims 4 to 8, wherein the first adhesive member (141) is disposed to extend to the edge (155) of the frame (150).

10. The display device (100) according to claim 9, wherein each of the first adhesive member (141) and the second adhesive member (142) is a double-sided tape.

11. The display device (100) according to claim 9 or 10, wherein the at least one step area (158, 159) of the frame (150) includes a first step area (158) and a second step area (159), and
wherein in each of the first step area (158) and the second step area (159), a part of each of the first adhesive member (141) and the second adhesive member (142) does not overlap the cover member (180).

12. The display device (100) according to claim 1 or 2, wherein the plurality of adhesive members (141, 142) include a first adhesive member (141) and a second adhesive member (142), and
wherein the first adhesive member (141) and the second adhesive member (142) overlap each other in direct contact with each other.

13. The display device (100) according to claim 12, wherein the frame (150) includes a first sub area (152a), a second sub area (152c), and a step area (158) among the at least one step area (158, 159) disposed between the first and second sub areas (152a, 152c), and
wherein the second adhesive member (142) covers the second sub area (152c) and the step area (158).

14. The display device (100) according to claim 13, wherein the first adhesive member (141) covers the first sub area (152a), the step area (158) and a part of the second sub area (152c).

15. The display device (100) according to claim 14, wherein an edge of the first adhesive member (141) abuts an edge of a first substrate (111) of the display panel (110),
wherein, preferably, the edge of the first adhesive member (141) is a vertical edge.
